# EUROPEAN PATENT APPLICATION

(11) **EP 4 704 136 A1**
(43) Date of publication of application: **04.03.2026**
(21) Application number: 25195961.5
(22) Date of filing: 14.08.2025
(51) Int. Cl.: H01J 37/147, H01J 37/317

(54) **CONTROLLING INCIDENCE ANGLE OF ION BEAM BY SAMPLE BIASING**

(30) Priority: 27.08.2024 US 202418816886
(71) Applicant: FEI COMPANY, Hillsboro, OR 97124 (US)
(72) Inventor: VELCOVSKÝ, Jaroslav, Brno (CZ); HOLZER, Jakub, Brno (CZ); ZELENKA, Franti ek, Brno (CZ); ZÁBRANSKÝ, Luká, Brno (CZ)
(74) Representative: Boult Wade Tennant LLP

(57) **Abstract**

An ion beam milling system includes a vacuum chamber, an ion column (302) for directing an ion beam toward a sample, and a stage (306) disposed inside the vacuum chamber and configured for mounting a holder to support the sample. The stage includes a stage surface disposed at a first angle relative to an axis of the ion column. An electrical bias is applied to the stage to adjust an incident angle of the ion beam with respect to the stage surface. A method for milling a sample using an ion beam milling system includes providing the ion beam milling system applying an electrical bias to the stage for adjusting an incident angle of the ion beam with respect to the stage surface, and, after applying the electrical bias to the stage, milling a sample surface of the sample using the ion beam.

## Description

The present disclosure is directed to low angle milling. More particularly, the present disclosure describes methods and systems for biasing stages for diverting ion beams in low angle milling.

### BACKGROUND

Combined focused ion beam scanning electron microscopy (FIB-SEM) is a key technology in the life sciences and has become a common method for 3D analysis of biological samples at high resolution. Plasma-FIB (PFIB) SEM tomography is based on the cross-section technique, where the sample is perpendicular to the ion beam and remains tilted during the imaging process.

### SUMMARY

According to one embodiment, an ion beam milling system includes a vacuum chamber, an ion column for directing an ion beam toward a sample, and a stage disposed inside the vacuum chamber and configured for mounting a holder to support the sample. The stage includes a stage surface disposed at a first angle relative to an axis of the ion column. An electrical bias is applied to the stage to adjust an incident angle of the ion beam with respect to the stage surface.

The system may include various optional embodiments. The incident angle of the ion beam may be based at least in part on one or more of a bias level of the electrical bias or an energy level associated with the ion beam. The bias level of the electrical bias may be greater than or equal to 3.0 kV. The energy level associated with the ion beam may include a landing energy that is less than or equal to 30 keV. The holder may include a pre-tilted holder to support the sample. The first angle may be less than or equal to 28 degrees. The system may further include an electron column for directing an electron beam toward the sample. A normal of the stage surface may be disposed at a second angle relative to the electron column. The second angle may be between 0 and -10 degrees. Application of the electrical bias to the stage may enable use of the ion beam to mill substantially all of a sample surface of the sample without colliding the sample or sample holder with an end of the ion column. The stage may include a tilt stage configured to tilt the holder to adjust the first angle and the second angle. The system may be configured to mill samples less than or equal to 6 inches in diameter in any direction.

According to another embodiment, a method for milling a sample using an ion beam milling system includes providing an ion beam milling system including a vacuum chamber, an electron column for directing an electron beam toward a sample, an ion column for directing an ion beam toward the sample, and a stage disposed inside the vacuum chamber and configured for mounting a holder to support the sample, the stage having a stage surface disposed at a first angle relative to an axis of the ion column. The method further includes applying an electrical bias to the stage for adjusting an incident angle of the ion beam with respect to the stage surface, and, after applying the electrical bias to the stage, milling a sample surface of the sample using the ion beam.

The method may include various optional embodiments. Applying the electrical bias to the stage for adjusting the incident angle of the ion beam with respect to the stage surface may generate an electrical field between an end of the electron column and the stage surface. The method may further include imaging the milled sample surface. The method may further include varying the electrical bias applied to the stage during the milling. The system may be configured to mill samples less than or equal to 6 inches in diameter in any direction.

According to yet another embodiment, the ion beam milling system includes a vacuum chamber, an ion column for directing an ion beam toward a sample, an electron column for directing an electron beam toward the sample, and a stage disposed inside the vacuum chamber including a stage surface to support the sample. An electrical bias is applied to the stage to adjust an incident angle of the ion beam with respect to the stage surface.

The system may include various optional embodiments. The incident angle of the ion beam is based at least in part on one or more of a bias level of the electrical bias or an energy level associated with the ion beam. The system may be configured to mill samples less than or equal to 6 inches in diameter in any direction.
Further aspects of the invention are set out in the following numbered clauses:
1. An ion beam milling system comprising:
   a vacuum chamber;
   an ion column for directing an ion beam toward a sample; and
   a stage disposed inside the vacuum chamber and configured for mounting a holder to support the sample, the stage having a stage surface disposed at a first angle relative to an axis of the ion column,
   wherein an electrical bias is applied to the stage to adjust an incident angle of the ion beam with respect to the stage surface.
2. The system of clause 1, wherein the incident angle of the ion beam is based at least in part on one or more of a bias level of the electrical bias or an energy level associated with the ion beam.
3. The system of clause 2, wherein the bias level of the electrical bias is greater than or equal to 3.0 kV.
4. The system of clause 2, wherein the energy level associated with the ion beam comprises a landing energy that is less than or equal to 30 keV.
5. The system of clause 1, wherein the holder comprises a pre-tilted holder to support the sample.
6. The system of clause 1, wherein the first angle is between 0 and 90 degrees.
7. The system of clause 1, further comprising an electron column for directing an electron beam toward the sample.
8. The system of clause 7, wherein a normal of the stage surface is disposed at a second angle relative to the electron column.
9. The system of clause 8, wherein the second angle is between -38 and 52 degrees.
10. The system of clause 7, wherein application of the electrical bias to the stage enables use of the ion beam to mill substantially all of a sample surface of the sample without colliding the sample or sample holder with an end of the ion column.
11. The system of clause 7, wherein the stage comprises a tilt stage configured to tilt the holder to adjust the first angle and the second angle.
12. The system of clause 1, wherein the system is configured to mill samples less than or equal to 6 inches in diameter in any direction.
13. A method for milling a sample using an ion beam milling system, the method comprising:
   providing an ion beam milling system comprising:
      a vacuum chamber;
      an electron column for directing an electron beam toward a sample;
      an ion column for directing an ion beam toward the sample; and
      a stage disposed inside the vacuum chamber and configured for mounting a holder to support the sample, the stage having a stage surface disposed at a first angle relative to an axis of the ion column; and
   applying an electrical bias to the stage for adjusting an incident angle of the ion beam with respect to the stage surface; and
   after applying the electrical bias to the stage, milling a sample surface of the sample using the ion beam.
14. The method of clause 13, wherein applying the electrical bias to the stage for adjusting the incident angle of the ion beam with respect to the stage surface generates an electrical field between an end of the electron column and the stage surface.
15. The method of clause 13, further comprising imaging the milled sample surface.
16. The method of clause 13, further comprising varying the electrical bias applied to the stage during the milling.
17. The method of clause 13, wherein the system is configured to mill samples less than or equal to 6 inches in diameter in any direction.
18. An ion beam milling system comprising:
   a vacuum chamber;
   an ion column for directing an ion beam toward a sample;
   an electron column for directing an electron beam toward the sample; and
   a stage disposed inside the vacuum chamber and comprising a stage surface to support the sample,
   wherein an electrical bias is applied to the stage to adjust an incident angle of the ion beam with respect to the stage surface.
19. The system of clause 18, wherein the incident angle of the ion beam is based at least in part on one or more of a bias level of the electrical bias or an energy level associated with the ion beam.
20. The system of claim 18, wherein the system is configured to mill samples less than or equal to 6 inches in diameter in any direction.

### DESCRIPTION OF THE DRAWINGS

The foregoing aspects and many of the attendant advantages of the present disclosure will become more readily appreciated as the same become better understood by reference to the following detailed description, when taken in conjunction with the accompanying drawings.
FIG. 1 is a schematic diagram of an example dual beam system for preparing samples, according to some embodiments.
FIG. 2A illustrates a PFIB and a SEM with respect to a sample in a PFIB-SEM Spin Mill system, according to some embodiments.
FIG. 2B illustrates an inset of FIG. 2A including the geometry of the PFIB-SEM Spin Mill system, according to some embodiments.
FIG. 3 is a schematic of an exemplary stage bias system for diverting ion beams, according to some embodiments.
FIG. 4 is a graph illustrating the impact of applying a positive electrical bias to a stage, according to some embodiments.
FIG. 5A illustrates a PFIB and a SEM with respect to a sample with applied positive stage bias, according to some embodiments.
FIG. 5B illustrates an inset of FIG. 5A including the geometry of the PFIB-SEM Spin Mill system, according to some embodiments.
FIG. 6 is a flowchart of a method of milling a sample using an ion beam milling system, according to some embodiments.
FIG. 7 depicts a block diagram of an example computer system usable with systems and methods according to embodiments of the present disclosure.

### DETAILED DESCRIPTION

While exemplary embodiments have been illustrated and described, it will be appreciated that various changes can be made therein without departing from the spirit and scope of the disclosure.

Angle milling is a machining process used to remove material from a sample at an angle other than 90° to the machine axis. An ideal ion-milled sample may include large, thin areas in selected regions, minimal top and bottom surface amorphization, and minimal preferential etching of adjacent materials. Minimizing the incident angle of the ion beam to the surface of the sample may fulfill at least some of these requirements.

Low angle milling methods are based on removing a thin layer from the sample surface at a nearly glancing angle, which can also be described as a method to polish horizontal planes. A broad area up to 1 mm in diameter can be irradiated with a plasma ion beam using xenon, argon, nitrogen or, most commonly, oxygen in life science resin-embedded samples at a glancing angle. Commonly used angles are between 1° and 5°, but most often 4° is used.

According to an exemplary application, the stage is periodically rotated to a series of pre-defined milling sites referred to as Spin Mill position. The number of milling positions can contribute to optimized quality of the sample surface. Most commonly, 5 milling positions are used. A full rotation of 360° under the ion beam constitutes a single milling slice.

Various known methods of low angle milling may require a pre-tilted holder or stages with extended negative tilt to achieve small glancing angles. For example, spin milling methods using multi-directional low angle milling may limited to relatively small samples up to 12.5 mm in diameter where the achievable area has a radius of only 4 mm from the center of rotation. Furthermore, processing primarily takes place near the center of the sample rather than across the entire area of the sample. Larger samples may be processed with pre-tilted holders and the achievable area is at the edge of a specimen. However, samples are still limited by size due to potential obstruction of the ion column (e.g., an edge of a large sample may contact the ion column and prevent or obstruct performance of the ion column). Accordingly, both pre-tilted holders and stages with extended negative tilts have geometric limitations.

Various embodiments of the present disclosure enable spin milling at high angles which further enables larger specimens to be processed. Furthermore, biasing the stage according to embodiments described herein improve the quality of the milled area and further enable spin milling on tools with no extended negative tilt. For example, embodiments of the present disclosure provide methods and systems for diverting an ion beam by biasing a stage supporting a sample.

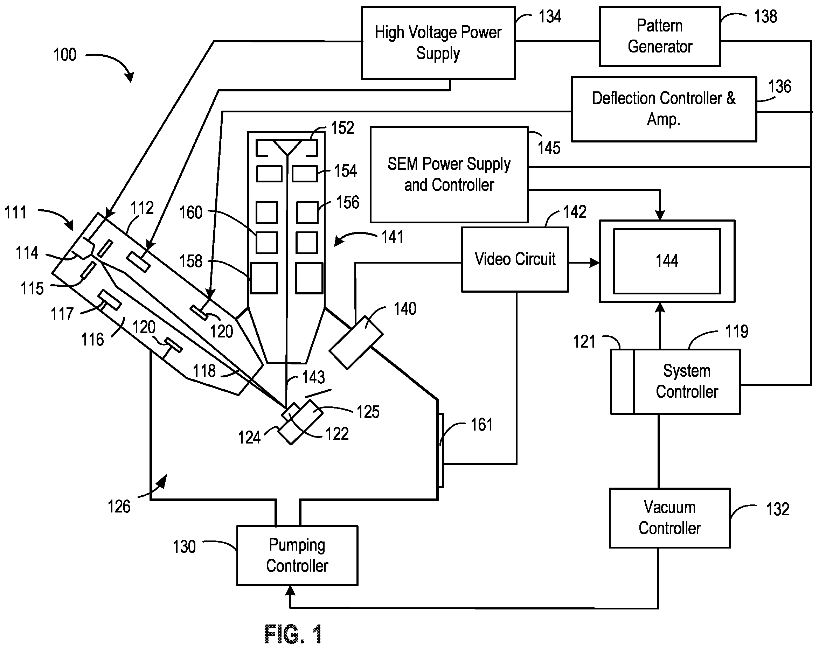

FIG. 1 is a schematic diagram of an example dual beam system 100, according to some embodiments. System 100 may be used to implement the low angle milling techniques discussed herein. In some embodiments, the system 100 will perform sample milling. However, in other embodiments, the milling algorithms may be performed by a computing system coupled to system 100, such as at a user's desk or a cloud based computing system. While an example of suitable hardware is provided below, the present disclosure is not limited to being implemented in any particular type of hardware. Various embodiments of low angle milling as described herein may be implemented using one or more algorithms performed the computing system coupled to system 100.

An SEM 141, along with power supply and control unit 145, is provided with the dual beam system 100. An electron beam 143 is emitted from a cathode 152 by applying voltage between cathode 152 and an anode 154. Electron beam 143 is focused to a fine spot by means of a condensing lens 156 and an objective lens 158. Electron beam 143 is scanned two-dimensionally on the specimen by means of a deflector 160. Operation of condensing lens 156, objective lens 158, and deflector 160 is controlled by power supply and control unit 145.

Electron beam 143 can be focused onto sample 122, which is on stage 125 within lower chamber 126. Sample122 may be located on a surface of stage 125 or on sample holder 124, which extends from the surface of stage 125.

When the electrons in the electron beam strike sample 122, secondary electrons are emitted. These secondary electrons are detected by secondary electron detector 140.

System 100 also includes FIB system 111 which includes an evacuated chamber having an ion column 112 within which are located an ion source 114 and focusing components 116 including extractor electrodes and an electrostatic optical system. The axis of focusing column 116 may be tilted, 52 degrees for example, from the axis of the electron column 141. The ion column 112 includes an ion source 114, an extraction electrode 115, a focusing element 117, deflection elements 120, which operate in concert to form focused ion beam 118. Focused ion beam 118 passes from ion source 114 through focusing components 116 and between electrostatic deflection means schematically indicated at 120 toward substrate 122, which may include, for example, a semiconductor wafer positioned on movable stage 125 within lower chamber 126.

Stage 125 can move in a horizontal plane (X and Y axes) and vertically (Z axis). Stage 125 can also tilt and rotate about the Z axis.

A door 161 is opened for inserting substrate 122 onto stage 125. Depending on the tilt of the stage 124/125, the Z axis will be in the direction of the optical axis of the relevant column. For example, during a data gathering stage of the disclosed techniques, the Z axis will be in the direction, e.g., parallel with, the FIB optical axis as indicated by the ion beam 118. In such a coordinate system, the X and Y axis will be referenced from the Z-axis. For example, the X-axis may be in and out of the page showing FIG. 1, whereas the Y-axis will be in the page, all while all three axes maintain their perpendicular nature to one another.

The chamber 126 is evacuated with turbomolecular and mechanical pumping system 130 under the control of vacuum controller 132. The vacuum system provides within chamber 126 a vacuum of between approximately 1×10⁻⁷ Torr and 5×10⁻⁴ Torr. If an etch assisting, an etch retarding gas, or a deposition precursor gas is used, the chamber background pressure may rise, typically to about 1×10⁻⁵ Torr.

The high voltage power supply provides an appropriate acceleration voltage to electrodes in focusing column 116 for energizing and focusing ion beam 118. When it strikes sample 122, material is sputtered, that is physically ejected, from the sample. Alternatively, ion beam 118 can decompose a precursor gas to deposit a material.

High voltage power supply 134 is connected to ion source 114 as well as to appropriate electrodes in ion beam focusing components 116 for forming an approximately 500 eV to 30 keV ion beam 118 and directing the same toward a sample. Deflection controller and amplifier 136, operated in accordance with a prescribed pattern provided by pattern generator 138, is coupled to deflection plates 120 whereby ion beam 118 may be controlled manually or automatically to trace out a corresponding pattern on the upper surface of substrate 122. In some systems the deflection plates are placed before the final lens, as is well known in the art. Beam blanking electrodes (not shown) within ion beam focusing column 116 cause ion beam 118 to impact onto blanking aperture (not shown) instead of sample 122 when a blanking controller (not shown) applies a blanking voltage to the blanking electrode.

The ion source 114 typically provides an ion beam based on the type of ion source. In some embodiments, the ion source 114 is a liquid metal ion source that can provide a gallium ion beam, for example. In other embodiments, the ion source 114 may be plasma-type ion source that can deliver a number of different ion species, such as oxygen, xenon, argon, nitrogen, etc. The ion source 114 typically is capable of being focused into a sub one-tenth micrometer wide beam at substrate 122 for either modifying the substrate 122 by ion milling, ion-induced etching, material deposition, or for the purpose of imaging the substrate 122.

A charged particle detector 140, such as an Everhart-Thornley detector or multichannel plate, used for detecting secondary ion or electron emission is connected to a video circuit 142 that supplies drive signals to video monitor 144 and receiving deflection signals from a system controller 119. The location of charged particle detector 140 within lower chamber 126 can vary in different embodiments. For example, a charged particle detector 140 can be coaxial with the ion beam and include a hole for allowing the ion beam to pass. In other embodiments, secondary particles can be collected through a final lens and then diverted off axis for collection.

System controller 119 controls the operations of the various parts of dual beam system. Through system controller 119, a user can cause ion beam 118 or electron beam 143 to be scanned in a desired manner through commands entered into a conventional user interface (not shown). Alternatively, system controller 119 may control dual beam system in accordance with programmed instructions stored in a memory 121. In some embodiments, dual beam system incorporates image recognition software to automatically identify regions of interest, and then the system can manually or automatically extract samples in accordance with the present disclosure. For example, the system could automatically locate similar features on semiconductor wafers including multiple devices and take samples of those features on different (or the same) devices.

Layers of sample 122 can be removed from the working surface.. Layers can be removed in smaller "slices" according to certain embodiments, in which slices of about 1 nm to 5 nm are removed sequentially. After the slice is removed, the newly exposed surface is imaged. The process of image acquisition and slice removal may be repeated for 25, 50, 75, or 100 times, but any other number of slices are contemplated herein.

The removal of a layer of material from the sample 122 can be done by directing the FIB 118 toward a portion of the sample 122 in a pattern. For example, the ion beam may raster over the surface of the sample 122 in the portion, removing the desired layer. Embodiments of the present disclosure provide methods and systems for diverting an ion beam and removing the desired layer from the sample 122 using the diverted ion beam.

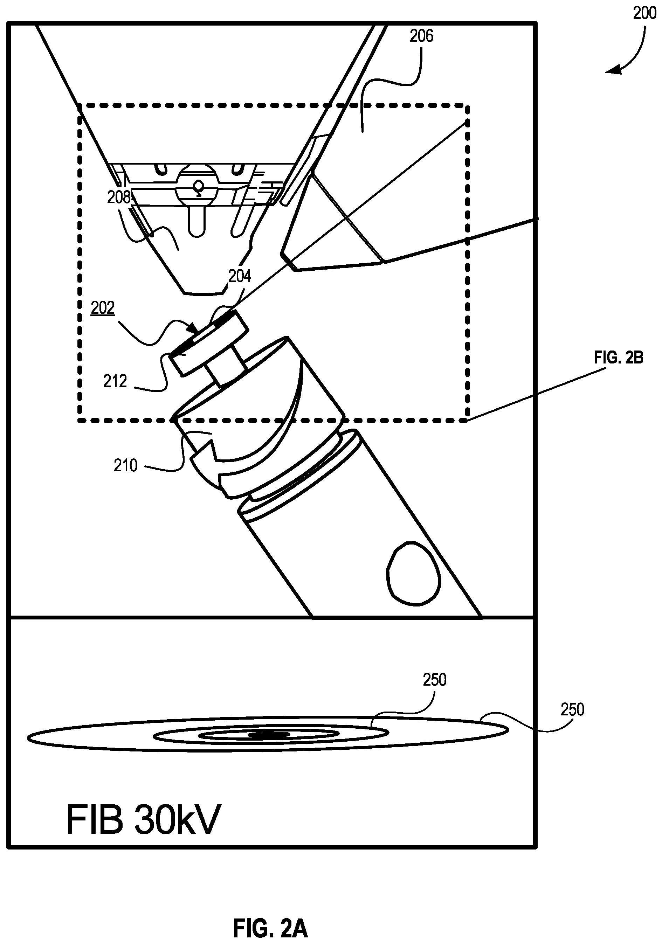

FIG. 2A illustrates a PFIB and a SEM with respect to a sample in a PFIB-SEM Spin Mill system. System 200 may be configured for removing a thin layer from a sample surface 202 of a sample 204. In particular, the system 200 includes an ion column 206 for directing an ion beam toward the sample surface 202 for polishing horizontal planes of the sample 204. System 200 may further include an electron column 208 for directing an electron beam toward the sample surface 202. System 200 may include a stage 210 configured for mounting a holder 212 to support the sample 204 having the sample surface 202.

As further shown in FIG. 2A, one or more test features 250 may be formed in the sample surface 202 and/or a test sample (not shown) to illustrate the accuracy and/or effectiveness of the milling parameters or the like. As shown, the one or more test features 250 may include a series of concentric circles with a central "x" marking, however, any shape or combination of shapes may be used without limitation.

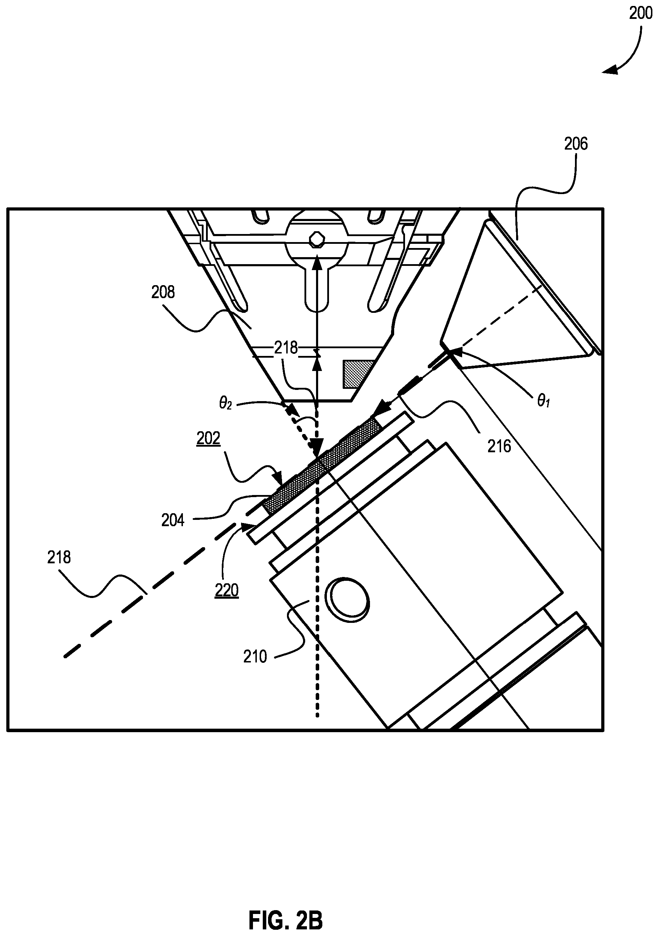

FIG. 2B illustrates an inset of FIG. 2A including the geometry of the PFIB-SEM Spin Mill system. As shown in FIG. 2B, an ion column 206 directs an ion beam 216 toward the sample 204 and an electron column 208 directs an electron beam 218 toward the sample 204. A stage 210 includes a stage surface 220 disposed at an angle relative an axis of the ion beam 216. A broad area of the sample surface 202 up to 1 mm in diameter can be irradiated with a plasma ion beam using xenon, argon, nitrogen or, most commonly, oxygen in life science resin-embedded samples at a glancing angle. Commonly used angles are between 1° and 5°, but most often 4°. The stage 210 is periodically rotated to a series of pre-defined milling sites. The stage 210 may be tilted to an angle *θ₂* of about -34° with the ion beam at an angle *θ₁* of 4° relative to the sample surface 202, as illustrated in FIG. 2B.

Low angle milling methods such as planar deprocessing or polishing as illustrated by FIGS. 2A and 2B are limited by the geometry of the ion column and the specimen dimensions. For example, spin milling methods using multi-directional low angle milling may limited to relatively small samples up to 12.5 mm in diameter where the achievable area has a radius of only 4 mm from the center of rotation and samples may be limited by size due to potential obstruction of the ion column, as described above.

To address these various limitations, various embodiments of the present disclosure enable spin milling at high angles which further enables larger specimens to be processed. Furthermore, biasing the stage according to embodiments described herein improve the quality of the milled area and further enable spin milling on tools with no extended negative tilt.

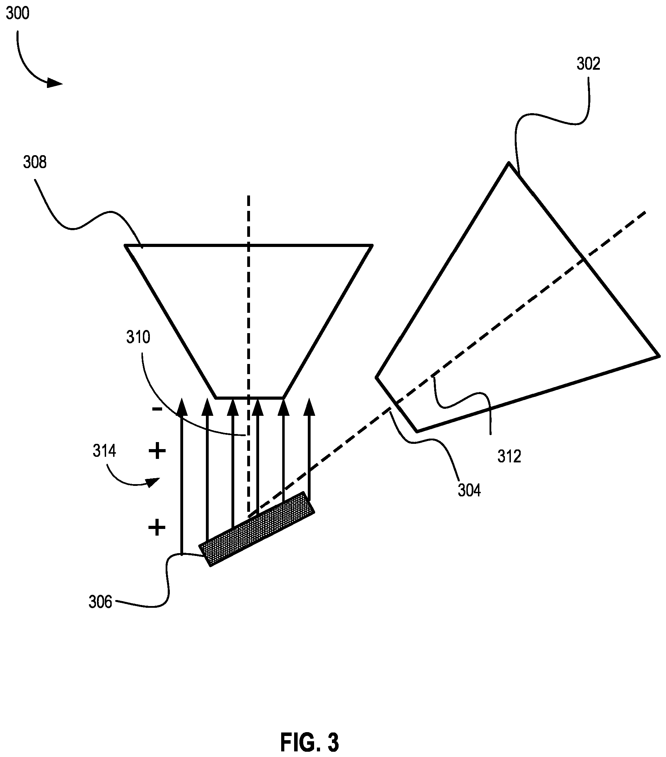

Embodiments of the present disclosure provide methods and systems for diverting an ion beam by biasing a stage supporting a sample. According to various embodiments, an ion beam may be diverted by an electric field according to Coulomb's law. FIG. 3 is a schematic of an exemplary stage bias system for diverting ion beams. A system 300 according to various embodiments includes an ion column 302 for directing an ion beam 304 at the sample 306. In at least some embodiments, the system 300 may further include an electron column 308 for directing an electron beam 310 at the sample 306. A positive electrical bias may be applied to the sample 306 through a stage and/or to the stage itself for diverting the ion beam 304 away from an axis 312 of the ion column 302 as shown in FIG. 3. An electrical filed is created between conductive components of the system (e.g., the electron column 308 and the sample 306). For example, applying the positive electrical bias generates an electrical field 314 between the electron column 308 (e.g., in particular, the end of the electron column 308) and the sample 306. In particular, applying the positive electrical bias generates an electrical field 314 between the electron column 308 and the sample 306 such that a path of positively charged particles curved against the sample 306 and diverts the ion beam 304 proximate to the sample 306 as shown in FIG. 3. Accordingly, the incident angle between the sample 306 and the ion beam 304 is decreased based at least in part on the acceleration voltage of the ion beam 304 and/or the electrical bias applied to the stage and/or to the sample 306. For example, an incident angle may be decreased by increasing the electrical bias applied to the stage and/or to the sample 306 and/or by decreasing the acceleration voltage. According to various embodiments, an electrical bias is applied to the stage to adjust an incident angle of the ion beam with respect to the stage surface.

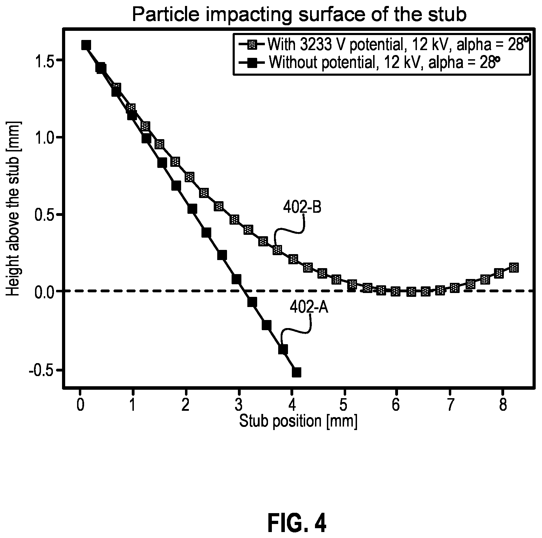

FIG. 4 is a graph illustrating the impact of applying a positive electrical bias to a stage. The y-axis represents the height above the sample (e.g., "height above the stub [mm]") and the x-axis represents the position of the sample relative to the ion beam (e.g., "stub position [mm]"). Ion beam 402-A represents the particles impacting the surface of the sample without a potential applied to the sample and/or to the stage. Ion beam 402-B represents the particles impacting the surface of the sample with a potential applied to the sample and/or to the stage. The potential applied in the impact illustrated by the squares is 3233 V. For each of the impacts, a 12 kV acceleration voltage was applied where an angle between the ion beam and the sample (such as *θ₁* as shown in FIG. 2B) is 28°. As shown in the figure, biasing the stage to even a few thousand Volts (e.g., ~3000 V) results in the ion beam represented by the squares was deflected away from the sample and decreased the incident angle up to parallel geometry.

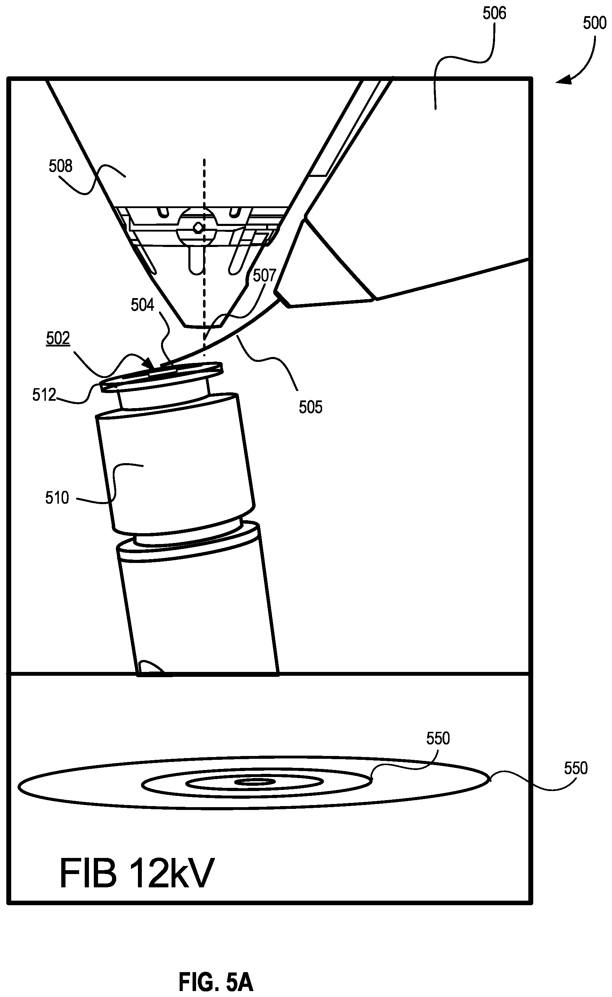

FIG. 5A illustrates a PFIB and a SEM with respect to a sample, according to some embodiments. System 500 may be configured for removing a thin layer from a sample surface 502 of a sample 504. In particular, the system 500 includes an ion column 506 for directing an ion beam 505 toward the sample surface 502 for polishing horizontal planes of the sample 504. System 500 may further include an electron column 508 for directing an electron beam 507 toward the sample surface 502. System 500 may include a stage 510 configured for mounting a holder 512 to support the sample 504 having the sample surface 502. System 500 may further include a vacuum chamber (not shown) according to various embodiments. Various components described herein may be at least partially disposed within the vacuum chamber during milling or the like. In contrast to the one or more test features 250 shown in FIG. 5A, the one or more test features 550 will have relatively jagged edges caused by an inhomogeneous electrical field, as compared to test features formed using embodiments of the present disclosure, to be described in further detail below.

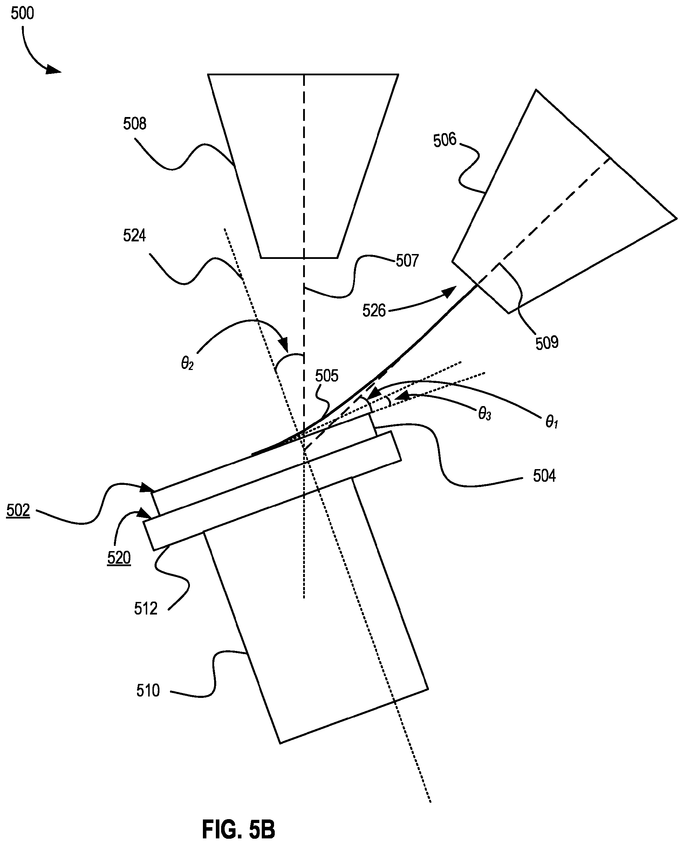

FIG. 5B illustrates an inset of FIG. 5A including the geometry of the PFIB-SEM Spin Mill system. As shown in FIG. 5B, an ion column 506 directs an ion beam 505 toward the sample 504 and an electron column 508 directs an electron beam 507 toward the sample 504. A stage 510 includes a stage surface 520 disposed at a first angle *θ₁* relative an axis 509 of the ion column 506. The first angle *θ₁* may be less than or equal to 28 degrees (e.g., 28°), according to various embodiments described herein. According to various embodiments, the first angle *θ₁* may be between greater than 0° to 90°. In yet other embodiments, the first angle *θ₁* may be 5 degrees and 40 degrees. In exemplary embodiments, the first angle *θ₁* is 28°. In various embodiments, a normal 524 of the stage surface 520 is disposed at a second angle *θ₂* relative to the electron column 508. The normal 524 may be coincident with an axis of the stage 510 and a rotation axis of the stage 510. The second angle *θ₂* may be between -38° to 52° according to at least some embodiments. A third angle *θ₃* is formed between the diverted ion beam 505 between the sample surface 502. According to at least some embodiments, the second angle *θ₂* (and the resulting third angle *θ₃*) may be adjusted by using a tilted sample holder and/or a tilted stage. The stage 510 may move in a horizontal plane (X and Y axes) and vertically (Z axis) and the stage 510 may be further tilted and rotated about the Z axis.

According to various embodiments, an electrical bias is applied to the stage 510 to adjust an incident angle of the ion beam 505 with respect to the stage surface 520. The incident angle is based at least in part on one or more of a bias level of the electrical bias or an energy level associated with the ion beam 505. In at least some embodiments, the bias level of the electrical bias is greater than or equal to 3.0 kV. For example, the bias level of the electrical bias may be between 1.0 keV and 5.0 kV. In yet further embodiments, the bias level of the electrical bias may be between 1.0 keV and 10.0 kV. In various embodiments, the energy level associated with the ion beam 505 includes a landing energy that is less than or equal to 30 keV. By biasing the stage 510 (or the sample 504 via the stage 510), the ion beam 505 is diverted (e.g., curved) such that the charged ion beam 505 becomes about parallel with the sample surface 502 at the impact as illustrated by the squares in the curve of FIG. 4. In one exemplary embodiment, by applying an accelerating voltage of 12 kV, the ion beam 505 may be diverted by 28 degrees, thus enabling milling on a sample tilted only to -10 degrees (e.g., having a second angle *θ₂* of -10 degrees). Accordingly, embodiments of the present disclosure enable spin milling on products (e.g., stages) that do not have extended negative tilt capabilities (e.g., up to -38 degrees or the like).

Application of the electrical bias to the stage 510 enables use of the ion beam 505 to mill substantially all of a sample surface 502 without an end 526 of the ion column 506 colliding with the sample 504, or any other in-chamber accessories. Advantageously, embodiments of the present disclosure enable processing of relatively larger samples that are capable of being processed with conventional techniques and systems. For example, the system 500 is configured to mill samples that are greater than or equal to ½ inch across and up to 6 inches across in direction X and Y. For example, a diameter of a sample may be at least 6 inches across the sample.

In some embodiments, the holder 512 may be a pre-tilted holder for supporting the sample 504. The stage 510 may include a tilt state (not shown) configured to tilt the holder 512 to adjust the first angle *θ₁* and the second angle *θ₂*.

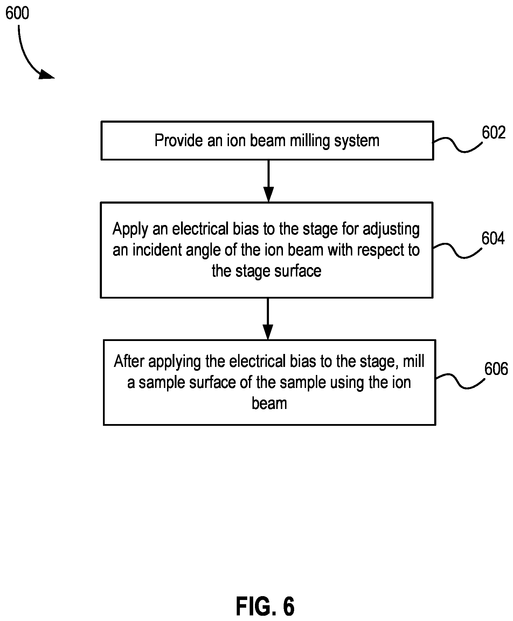

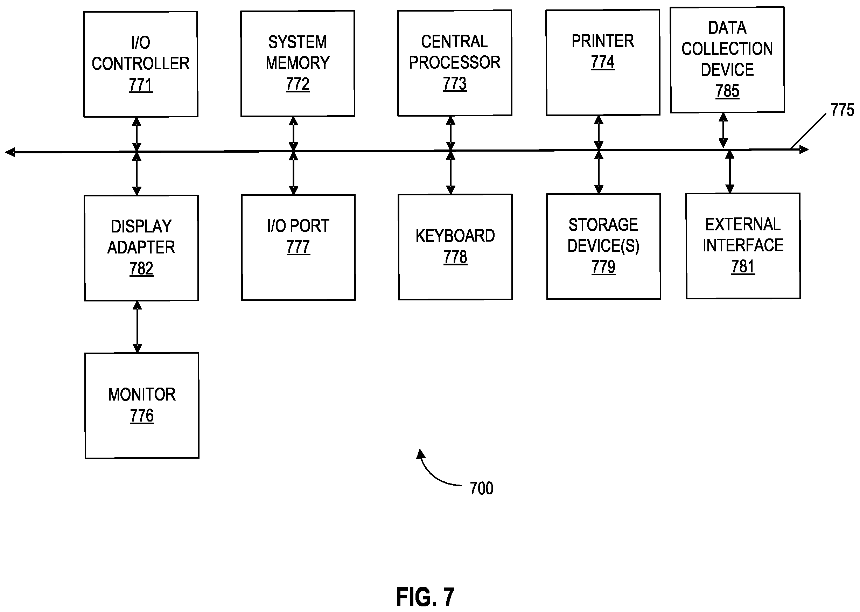

FIG. 6 is a flowchart of a method of milling a sample using an ion beam milling system. Method 600 may be performed using any of the embodiments described herein, particularly those described with respect to the ion beam milling system of FIGS. 5A and 5B. Furthermore, various embodiments of method 600 may be implemented by and/or performed by one or more components of computer system 700 described with respect to FIG. 7 below. Method 600 may include more or less operations than those described herein and at least some steps recited herein may be performed in alternative orders unless otherwise noted herein. Method 600 includes step 602. Step 602 includes providing an ion beam milling system. The system may include embodiments of system 500 as described in detail above. For example, the system may include a vacuum chamber, an electron column for directing an electron beam toward a sample, an ion column for directing an ion beam toward the sample, and a stage disposed inside the vacuum chamber and configured for mounting a holder to support the sample. The stage may have a stage surface disposed at a first angle relative to an axis of the ion column, as shown and described as first angle *θ₁* at least in FIG. 5B.

Method 600 further includes step 604. Step 604 includes applying an electrical bias to the stage for adjusting an incident angle of the ion beam with respect to the stage surface. The incident angle may be based at least in part on one or more of a bias level of the electrical bias or an energy level associated with the ion beam. According to various embodiments a "bias level" refers to a unit of electrical bias, such as the electrical bias in kV applied to the stage. An "energy level" as referred to herein refers to a unit of the landing energy of the ion beam. In at least some embodiments, the bias level of the electrical bias is greater than or equal to 3.0 kV. In various embodiments, the energy level associated with the ion beam includes a landing energy that is less than or equal to 30 keV. As described with respect to FIG. 5, applying the electrical bias to the stage for adjusting the incident angle of the ion beam with respect to the stage surface generates a homogeneous electrical field between an end of the electron column and the stage surface.

Method 600 further includes step 606. Step 606 includes, after applying the electrical bias to the stage, milling a sample surface of the sample using the ion beam. In various embodiments, method 600 may be performed in a spin milling application where the sample is rotated along a rotation axis (e.g., as shown in FIG. 5B, the normal 524 may be coincident with an axis of the stage 510 and a rotation axis of the stage 510). According to at least some embodiments, step 606 may include varying the electrical bias applied to the stage during the milling. For example, the applied stage bias may be changed dynamically to make corrections of the first angle such as when the sample normal is not perfectly parallel with a stage rotation axis. Accordingly, embodiments of the present disclosure provide a fine-tuned control of the glancing angle of the ion beam. The system is configured to mill samples greater than ½ inch across and up to 6 inches across in any direction.

Method 600 may further include imaging the milled sample surface. Imaging the milled surface may include various systems as would be appreciated by one having ordinary skill in the art upon reading the present disclosure. During traditional spin milling, the beam may scrape the surface at angles between 0.5 and 5 degrees. For longer spin mill jobs, this often creates deep cuts around the perimeter of the sample which may cause redeposition on the area of interest. Furthermore, due to crystallography, the milling rate is often different from grain to grain. When an electrical bias is applied to the stage according to embodiments of the present disclosure, the ion beam becomes parallel with the surface of the sample and these deep cuts around the area of interest are avoided. The face remains flat by reducing any contamination which commonly occurs during processing. Said another way, the coincidence point of the ion beam and the sample's surface is shifted away from the incidence point of the electron beam and the sample's surface, therefore, contamination does not reach the electron pole and thus reduces the contamination during the ion beam processing.

FIG. 7 depicts a block diagram of an example computer system usable with systems and methods according to embodiments of the present disclosure. Any of the computer systems mentioned herein may utilize any suitable number of subsystems. Examples of such subsystems are shown in FIG. 7 in computer system 700. In some embodiments, a computer system includes a single computer apparatus, where the subsystems can be the components of the computer apparatus. In other embodiments, a computer system can include multiple computer apparatuses, each being a subsystem, with internal components. A computer system can include desktop and laptop computers, tablets, mobile phones and other mobile devices.

The subsystems shown in FIG. 7 are interconnected via a system bus 775. Additional subsystems such as a printer 774, keyboard 778, storage device(s) 779, monitor 776 (e.g., a display screen, such as an LED), which is coupled to display adapter 782, and others are shown. Peripherals and input/output (I/O) devices, which couple to I/O controller 771, can be connected to the computer system by any number of means known in the art such as input/output (I/O) port 777 (e.g., USB, FireWire^{®}). For example, I/O port 777 or external interface 781 (e.g., Ethernet, Wi-Fi, etc.) can be used to connect computer system 700 to a wide area network such as the Internet, a mouse input device, or a scanner. The interconnection via system bus 775 allows the central processor 773 to communicate with each subsystem and to control the execution of a plurality of instructions from system memory 772 or the storage device(s) 779 (e.g., a fixed disk, such as a hard drive, or optical disk), as well as the exchange of information between subsystems. The system memory 772 and/or the storage device(s) 779 may embody a computer readable medium. Another subsystem is a data collection device 785, such as a camera, microphone, accelerometer, and the like. Any of the data mentioned herein can be output from one component to another component and can be output to the user.

A computer system can include a plurality of the same components or subsystems, e.g., connected together by external interface 781, by an internal interface, or via removable storage devices that can be connected and removed from one component to another component. In some embodiments, computer systems, subsystem, or apparatuses can communicate over a network. In such instances, one computer can be considered a client and another computer a server, where each can be part of a same computer system. A client and a server can each include multiple systems, subsystems, or components.

Aspects of embodiments can be implemented in the form of control logic using hardware circuitry (e.g., an application specific integrated circuit or field programmable gate array) and/or using computer software stored in a memory with a generally programmable processor in a modular or integrated manner, and thus a processor can include memory storing software instructions that configure hardware circuitry, as well as an FPGA with configuration instructions or an ASIC. As used herein, a processor can include a single-core processor, multicore processor on a same integrated chip, or multiple processing units on a single circuit board or networked, as well as dedicated hardware. Based on the disclosure and teachings provided herein, a person of ordinary skill in the art will know and appreciate other ways and/or methods to implement embodiments of the present disclosure using hardware and a combination of hardware and software.

Any of the software components or functions described in this application may be implemented as software code to be executed by a processor using any suitable computer language such as, for example, Java, C, C++, C#, Objective-C, Swift, or scripting language such as Perl or Python using, for example, conventional or object-oriented techniques. The software code may be stored as a series of instructions or commands on a computer readable medium for storage and/or transmission. A suitable non-transitory computer readable medium can include random access memory (RAM), a read only memory (ROM), a magnetic medium such as a hard-drive or a floppy disk, or an optical medium such as a compact disk (CD) or DVD (digital versatile disk) or Blu-ray disk, flash memory, and the like. The computer readable medium may be any combination of such devices. In addition, the order of operations may be re-arranged. A process can be terminated when its operations are completed but could have additional steps not included in a figure. A process may correspond to a method, a function, a procedure, a subroutine, a subprogram, etc. When a process corresponds to a function, its termination may correspond to a return of the function to the calling function or the main function.

Such programs may also be encoded and transmitted using carrier signals adapted for transmission via wired, optical, and/or wireless networks conforming to a variety of protocols, including the Internet. As such, a computer readable medium may be created using a data signal encoded with such programs. Computer readable media encoded with the program code may be packaged with a compatible device or provided separately from other devices (e.g., via Internet download). Any such computer readable medium may reside on or within a single computer product (e.g., a hard drive, a CD, or an entire computer system), and may be present on or within different computer products within a system or network. A computer system may include a monitor, printer, or other suitable display for providing any of the results mentioned herein to a user.

Any of the methods described herein may be totally or partially performed with a computer system including one or more processors, which can be configured to perform the steps. Any operations performed with a processor (e.g., aligning, determining, comparing, computing, calculating) may be performed in real-time. The term *"real-time"* may refer to computing operations or processes that are completed within a certain time constraint. The time constraint may be 1 minute, 1 hour, 1 day, or 7 days. Thus, embodiments can be directed to computer systems configured to perform the steps of any of the methods described herein, potentially with different components performing a respective step or a respective group of steps. Although presented as numbered steps, steps of methods herein can be performed at a same time or at different times or in a different order. Additionally, portions of these steps may be used with portions of other steps from other methods. Also, all or portions of a step may be optional. Additionally, any of the steps of any of the methods can be performed with modules, units, circuits, or other means of a system for performing these steps.

In the foregoing specification, embodiments of the disclosure have been described with reference to numerous specific details that can vary from implementation to implementation. The specification and drawings are, accordingly, to be regarded in an illustrative rather than a restrictive sense. The sole and exclusive indicator of the scope of the disclosure, and what is intended by the applicants to be the scope of the disclosure, is the literal and equivalent scope of the set of claims that issue from this application, in the specific form in which such claims issue, including any subsequent correction. The specific details of particular embodiments can be combined in any suitable manner without departing from the spirit and scope of embodiments of the disclosure.

Additionally, spatially relative terms, such as "bottom" or "top" and the like can be used to describe an element and/or feature's relationship to other element(s) and/or feature(s) as, for example, illustrated in the figures. It will be understood that the spatially relative terms are intended to encompass different orientations of the device in use and/or operation in addition to the orientation depicted in the figures. For example, if the device in the figures is turned over, elements described as a "bottom" surface can then be oriented "above" other elements or features. The device can be otherwise oriented (e.g., rotated 90 degrees or at other orientations) and the spatially relative descriptors used herein interpreted accordingly.

Terms "and," "or," and "an/or," as used herein, may include a variety of meanings that also is expected to depend at least in part upon the context in which such terms are used. Typically, "or" if used to associate a list, such as A, B, or C, is intended to mean A, B, and C, here used in the inclusive sense, as well as A, B, or C, here used in the exclusive sense. In addition, the term "one or more" as used herein may be used to describe any feature, structure, or characteristic in the singular or may be used to describe some combination of features, structures, or characteristics. However, it should be noted that this is merely an illustrative example and claimed subject matter is not limited to this example. Furthermore, the term "at least one of" if used to associate a list, such as A, B, or C, can be interpreted to mean any combination of A, B, and/or C, such as A, B, C, AB, AC, BC, AA, AAB, ABC, AABBCCC, etc.

Reference throughout this specification to "one example," "an example," "certain examples," or "exemplary implementation" means that a particular feature, structure, or characteristic described in connection with the feature and/or example may be included in at least one feature and/or example of claimed subject matter. Thus, the appearances of the phrase "in one example," "an example," "in certain examples," "in certain implementations," or other like phrases in various places throughout this specification are not necessarily all referring to the same feature, example, and/or limitation. Furthermore, the particular features, structures, or characteristics may be combined in one or more examples and/or features.

In some implementations, operations or processing may involve physical manipulation of physical quantities. Typically, although not necessarily, such quantities may take the form of electrical or magnetic signals capable of being stored, transferred, combined, compared, or otherwise manipulated. It has proven convenient at times, principally for reasons of common usage, to refer to such signals as bits, data, values, elements, symbols, characters, terms, numbers, numerals, or the like. It should be understood, however, that all of these or similar terms are to be associated with appropriate physical quantities and are merely convenient labels. Unless specifically stated otherwise, as apparent from the discussion herein, it is appreciated that throughout this specification discussions utilizing terms such as "processing," "computing," "calculating," "determining," or the like refer to actions or processes of a specific apparatus, such as a special purpose computer, special purpose computing apparatus or a similar special purpose electronic computing device. In the context of this specification, therefore, a special purpose computer or a similar special purpose electronic computing device is capable of manipulating or transforming signals, typically represented as physical electronic or magnetic quantities within memories, registers, or other information storage devices, transmission devices, or display devices of the special purpose computer or similar special purpose electronic computing device.

In the preceding detailed description, numerous specific details have been set forth to provide a thorough understanding of claimed subject matter. However, it will be understood by those skilled in the art that claimed subject matter may be practiced without these specific details. In other instances, methods and apparatuses that would be known by one of ordinary skill have not been described in detail so as not to obscure claimed subject matter. Therefore, it is intended that claimed subject matter is not limited to the particular examples disclosed, but that such claimed subject matter may also include all aspects falling within the scope of appended claims, and equivalents thereof.

## Claims

1. An ion beam milling system comprising:
a vacuum chamber;
an ion column for directing an ion beam toward a sample; and
a stage disposed inside the vacuum chamber and configured for mounting a holder to support the sample, the stage having a stage surface disposed at a first angle relative to an axis of the ion column,
wherein an electrical bias is applied to the stage to adjust an incident angle of the ion beam with respect to the stage surface.

2. The system of claim 1, wherein the incident angle of the ion beam is based at least in part on one or more of a bias level of the electrical bias or an energy level associated with the ion beam.

3. The system of claim 2, wherein the bias level of the electrical bias is greater than or equal to 3.0 kV.

4. The system of claim 2, wherein the energy level associated with the ion beam comprises a landing energy that is less than or equal to 30 keV.

5. The system of any preceding claim, wherein the holder comprises a pre-tilted holder to support the sample.

6. The system of any preceding claim, wherein the first angle is between 0 and 90 degrees.

7. The system of any preceding claim, further comprising an electron column for directing an electron beam toward the sample.

8. The system of claim 7, wherein a normal of the stage surface is disposed at a second angle relative to the electron column.

9. The system of claim 8, wherein the second angle is between -38 and 52 degrees.

10. The system of claim 7, wherein the stage comprises a tilt stage configured to tilt the holder to adjust the first angle and the second angle.

11. The system of any preceding claim, wherein the system is configured to mill samples less than or equal to 152 mm (6 inches) in diameter in any direction.

12. A method for milling a sample using an ion beam milling system, the method comprising:
providing an ion beam milling system comprising:
a vacuum chamber;
an electron column for directing an electron beam toward a sample;
an ion column for directing an ion beam toward the sample; and
a stage disposed inside the vacuum chamber and configured for mounting a holder to support the sample, the stage having a stage surface disposed at a first angle relative to an axis of the ion column; and
applying an electrical bias to the stage for adjusting an incident angle of the ion beam with respect to the stage surface; and
after applying the electrical bias to the stage, milling a sample surface of the sample using the ion beam.

13. The method of claim 12, wherein applying the electrical bias to the stage for adjusting the incident angle of the ion beam with respect to the stage surface generates an electrical field between an end of the electron column and the stage surface.

14. The method of claim 12 or claim 13, further comprising imaging the milled sample surface.

15. The method of any one of claims 12, 13 or 14, further comprising varying the electrical bias applied to the stage during the milling.
